# EUROPÄISCHE PATENTSCHRIFT

(11) **EP 0 591 312 B1**
(45) Veröffentlichungstag und Bekanntmachung des Hinweises auf die Patenterteilung: **06.08.1997**
(21) Anmeldenummer: 92912982.3
(22) Anmeldetag: 23.06.1992
(51) Int. Cl.: H01L 23/498, H01L 23/485, H01L 21/60, H01B 12/06

(54) **STRUKTURIERTE LEITERBAHNEN UND VERFAHREN ZUR HERSTELLUNG DERSELBEN**
STRUCTURED CONDUCTOR TRACKS AND PROCESS FOR MAKING THEM
PISTES CONDUCTRICES STRUCTUREES ET LEUR PROCEDE DE FABRICATION

(30) Priorität: 24.06.1991 DE 4120766; 14.02.1992 DE 4204370
(43) Veröffentlichungstag der Anmeldung: 13.04.1994
(73) Patentinhaber: FORSCHUNGSZENTRUM JÜLICH GMBH, 52425 Jülich (DE)
(72) Erfinder: COPETTI, Carlo, D-52428 Jülich (DE); SCHUBERT, Jürgen, D-50189 Elsdorf-Berrendorf (DE); ZANDER, Willi, D-5173 Aldenhoven-Neu Pattern (DE); BUCHAL, Christoph, D-5170 Jülich (DE)
(86) Internationale Anmeldenummer: DE9200518
(87) Internationale Veröffentlichungsnummer: WO9300708

(56) Entgegenhaltungen:
- EP-A- 0 307 147
- EP-A- 0 325 408
- EP-A- 0 338 631
- EP-A- 0 346 494
- EP-A- 0 347 470
- EP-A- 0 358 879

## Beschreibung

Die Erfindung bezieht sich auf strukturierte Leiterbahnen gemäß den Ansprüchen 11 und 15 und auf Verfahren zur Herstellung von strukturierten Leiterbahnen aus Hochtemperatursupraleiter (HTSL)-Schichten gemäß den Ansprüchen 1 und 8.

Ein Schwerpunkt der Entwicklungsaktivitäten auf dem Gebiet der HTSL-Technologie bildet die Herstellung von HTSL-Strukturen aus dünnen supraleitenden Schichten ("Filme"). Zur Herstellung derartiger Strukturen sind in den letzten Jahren hauptsächlich zwei Verfahren entwickelt worden.

Beim üblichen Verfahren wird auf einem Substrat, das für ein einkristallines Wachstum des HTSL geeignet ist, ein HTSL-Film durch Laserablation, Sputtern o.ä. abgeschieden. Anschließend wird auf den HTSL-Film in den Bereichen, die für die HTSL-Strukturen vorgesehen sind, zusätzlich eine Lackschicht aufgetragen, belichtet und entwickelt. Die Lackflächen schützen nun die abgedeckten Supraleiterflächen vor einem nachfolgenden Ätzschritt, durch den die nicht durch die Lackmaske geschützten Bereiche des HTSL-Films wieder von der Substratoberfläche abgetragen werden. Dieser Ätzprozeß kann naßchemisch oder durch Ionenstrahlätzen erfolgen. Nach Entfernen der Lackschicht ist das Endprodukt dieses Verfahrens somit ein auf der Substratoberfläche verlaufender, strukturierter HTSL-Film.

Die erwünschten supraleitenden Eigenschaften sind nun an die exakte chemische Zusammensetzung und Kristallinität des nach dem Ätzschritt verbliebenen, strukturierten HTSL-Films gebunden. Dabei sind insbesondere in den Oberflächenbereichen der HTSL-Strukturen aufgrund der elektrodynamischen Gesetze hohe elektrische Felder und starke Oberflächenströme zu erwarten. Ein Nachteil des beschriebenen Verfahrens ist nun, daß auch der strukturierte HTSL-Film an den durch den Ätzschritt geschaffenen und damit ungeschützten seitlichen Oberflächen während des Ätzvorganges degradiert wird. Dies hat eine Störung der Stöchiometrie und Kristallinität des HTSL-Films vor allem in diesen seitlichen Oberflächenbereichen zur Folge, so daß die Oberflächenströme von einem schlechten, teilweise resistiven Material aufgenommen werden. Daraus resultiert eine Verminderung der erwünschten, supraleitenden Eigenschaften der HTSL-Bahnen. Außerdem kann nicht ausgeschlossen werden, daß die Belackung auch die horizontalen Flächen des Supraleiters ungünstig beeinflußt.

Um eine derartige Degradation des strukturierten HTSL-Films durch Ätzen zu vermeiden, wurde ein weiteres Verfahren, das sog. "Inhibit-Verfahren" entwickelt. Hierbei wird zunächst auf das Substrat in den Oberflächenbereichen, die den strukturierten HTSL-Film tragen sollen, eine Lackschicht aufgebracht. Anschließend wird auf die gesamte Oberfläche ein Inhibit-Dotierstoff aufgedampft, wobei in den für die HTSL-Bahnen vorgesehenen Substratoberflächenbereichen die Lackmaske den Dotierstoff vom Substrat trennt. Bei einem nachfolgenden Lift-off-Prozeß wird die Lackmaske und damit gleichzeitig auch der auf der Lackmaske befindliche Dotierstoff aus den Bereichen des zukünftigen strukturierten HTSL-Films vom Substrat abgehoben. Auf die nunmehr dotierten und undotierten Bereiche der Substratoberfläche wird im nächsten Schritt die HTSL-Schicht deponiert. Die Deposition erfolgt in der Regel bei relativ hohen Substrattemperaturen von etwa 500 - 800°C. Das HTSL-Material kann aber auch bei niedrigen Temperaturen aufgebracht werden; es muß dann allerdings ein Temperschritt bei den angegebenen hohen Temperaturen angeschlossen werden.

Auf den undotierten Substratbereichen bildet sich nun durch einkristallines Wachstum der strukturierte HTSL-Film aus, während auf der dotierten Substratoberfläche das HTSL-Material durch vertikale Diffusion des Dotierstoffes zum Isolator wird. Allerdings tritt neben dieser erwünschten vertikalen Diffusion auch eine laterale Diffusion des Dotierstoffes in die supraleitenden Strukturen auf; denn die sich bildenden einkristallinen HTSL-Bahnen haben seitlich direkten Kontakt zum Dotierstoff. Die laterale Diffusion des Dotierstoffes in den strukturierten HTSL-Film hat zur Folge, daß sich innerhalb der Leiterbahnen ein Konzentrationsgradient des Dotierstoffes und damit ein allmählicher Übergang von "nichtleitend" über "schlecht leitend" zu "schlecht supraleitend" bis schließlich "gut supraleitend" herausbildet. Dieser resistive Übergangsbereich muß aber für die Anwendung von supraleitenden Strukturen insbesondere in der Mikroelektronik vermieden werden.

Es ist daher Aufgabe der Erfindung, alternative Verfahren der eingangs genannten Art zu schaffen, die es ermöglichen, HTSL-Strukturen herzustellen, deren supraleitende Eigenschaften durch den Herstellungsprozeß nicht beeinträchtigt werden. Es ist außerdem Aufgabe der Erfindung, HTSL-Leiterbahnen bereitzustellen, deren supraleitende Eigenschaften durch den Herstellungsprozeß nicht beeinträchtigt werden.

Die der Erfindung zugrundeliegende Aufgabe wird durch ein Verfahren mit den im Anspruch 1 definierten Merkmalen gelöst.

Die auf dem Substrat aufgebrachte Lackschicht bedeckt nach einer photolithographischen Strukturierung nur die durch aufwachsen von HTSL-Material mit supraleitenden Eigenschaften zwecks Bildung von Leiterbahnen vorgesehenen Bereiche. In einem nachfolgenden Verfahrensschritt wird nacheinander Substratmaterial und eine dünne Inhibitschicht abgeschieden. Als abzuscheidendes Substratmaterial kann dazu z.B. SrTiO₃, LaAlO₃, YSZ, MgO oder ein anderes, geeignetes Substratmaterial gewählt werden. Als Material für die abzuscheidende Inhibitschicht kann z.B. SiO₂ oder auch ein anderes geeignetes Material gewählt werden. In einem nachfolgenden Verfahrensschritt wird durch einen Lift-off der Lackmaske das sich auf dieser Lackmaske abgeschiedene Substrat- und Inhibitmaterial entfernt. In einem folgenden Verfahrensschritt erfolgt die Abscheidung des HTSL-Films bei Substrattemperaturen vorzugsweise im Bereich zwischen 500°C und 800°C. In den mit Inhibitstoff bedeckten Substratoberflächenbereichen wird dabei durch Diffusion des Inhibitstoffs in die abgeschiedene HTSL-Schicht diese zu einer Isolatorschicht degradiert. Das Wachstum eines supraleitenden epitaktischen Filmes erfolgt somit nur auf den freien Substratoberflächenbereichen. Diese sind gegenüber den die degradierten Isolatorschicht tragenden Substratoberflächenbereiche aufgrund der erfolgten Abscheidung von Substratmaterial relativ erniedrigt.

Die Abscheidung des Substratmaterials soll im Ergebnis dazu führen, daß die die Leiterbahnen tragenden Substratoberflächenbereiche in Richtung senkrecht der Substratoberfläche räumlich von den die Isolatorschicht tragenden Substratoberflächenbereiche soweit getrennt werden, daß eine laterale Diffusion des Inhibitstoffs in den die Leiterbahnen bildenden supraleitenden Film vermieden wird.

Das erfindungsgemäße Verfahren weist folgende Vorteile auf:
- Beim erfindungsgemäßen Verfahren erfolgt die Bildung der HTSL-Bahnen durch epitaktisches Wachstum an den Substratoberflächenbereichen, die nach dem Lift-off freigelegt worden sind. Mit der Bildung der HTSL-Bahnen erhalten diese aufgrund der vorher durchgeführten Maßnahme, insbesondere die Vergiftung des HTSL in den höher gelegenen mit Inhibitdotierstoff versehenen Substratbereichen, die erwünschte Strukturierung. Im Gegensatz zu den bekannten Verfahren erübrigt sich beim erfindungsgemäßen Verfahren das erforderliche Ätzen der HTSL-Schicht um die gewünschte Struktur zu erhalten. Die mit solchen Ätzverfahren verbundenen weiteren Möglichkeiten der Verunreinigung einer epitaktisch gewachsenen HTSL-Schicht kann damit vermieden werden.
- Während der Schichtabscheidung wird eine automatische Randpassivierung der die Leiterbahnen bildenden HTSL-Schicht erreicht.
   Die HTSL-Materialien sind stark anisotrop in ihrer Kristallstruktur. Dies bewirkt das die Sauerstoffdiffusion in diesen Materialien sehr stark Richtungsabhängig ist (parallel zur Substratoberfläche etwa um einen Faktor tausend mal schneller als in der Substratoberfläche senkrechten Richtung). Diese Sauerstoffdiffusion ist ein wesentlicher Degradationsmechanismus bei den HTSL-Materialien. Deshalb sind Flächen wie z.B. Kanten an denen durch Strukturierungsverfahren offene, zur Substratoberfläche parallel verlaufenen Richtungen freigelegt werden, sehr anfällig für diese Sauerstoffdiffusion. Das erfindungsgemäße Verfahren führt durch die Abscheidung von Substratmaterial in den zum Tragen der Isolatorschicht vorgesehenen Substratoberflächenbereichen im Ergebnis zur seitlichen Begrenzung des die HTSL-Leiterbahnen bildenden Filmes, und somit zu einer automatischen Randpassivierung an den senkrecht zur Substratoberfläche die Leiterbahnen begrenzenden Kanten. Ein dauerhafter Schutz dieser Kante wird somit erreicht.
- In einer vorteilhaften Variante des erfindungsgemäßen Verfahrens beansprucht (Anspruch 12) können weitere Degradationsmechanismen wie z.B die Reaktionen der HTSL-Schicht mit H₂O und CO₂, die z.B. in der Luft vorhanden sind, dadurch vermieden werden, daß auf den HTSL-Leiterbahnen eine weitere Deckschicht zwecks vollständiger Passivierung der Oberfläche der HTSL-Schicht aufgebracht werden.
- Eine erfolgreiche Nutzung der Hochtemperatursupraleitung in der Technik erfordert unter anderem das Beherrschen der Mehrlagentechnik, in der sich HTSL-Schichten und Isolator-Schichten abwechseln. Im Falle der möglichen vollständigen Passivierung im obigen Sinne gestattet das erfindungsgemäße Verfahren ohne weiteres eine dreidimensionale Anordnung strukturierter, in Substratmaterial vergrabener HTSL-Leiterbahnen.

Weitere zweckmäßige und vorteilhafte Varianten des Verfahrens sind in den Ansprüchen 2 bis 7 angegeben.

Eine besonders vorteilhafte Variante des erfindungsgemäßen Verfahrens ist dann gegeben, wenn als Material für die strukturierte Lackschicht amorphes YBaCuO gewählt wird.

Übliche zur Bildung von Masken bei Lift-off-Prozessen verwendeten Materialien sind bis etwa 500°C stabil. Bei höheren Temperaturen sind zur Maskentechnik eingesetzte Materialien nicht stabil. Es wird deshalb als Material für die an den für die HTSL-Bahnen vorgesehenen Substratoberflächenbereiche vorhandene, als Lackmaske für den Lift-off-Prozeß vorgesehene, geeignet strukturierte Lackschicht amorphes YBaCuO vorgeschlagen. Eine Lackmaske aus diesem Material kann in bekannter Weise mit Hilfe üblicher Lift-off-Prozesse beispielsweise bei Zimmertemperatur hergestellt werden.

Bei der Wahl von amorphem YBaCuO als für das erfindungsgemäße Verfahren geeignete Lackschicht, kann die Abscheidung von Substratmaterial in den lackfreien Substratbereichen bei relativ hohen Temperaturen erfolgen. Beispielsweise besteht die Möglichkeit, SrTiO₃ als Substratmaterial bei 800°C in den lackfreien Substratbereichen abzuscheiden. Unter diesen Bedingungen scheidet sich das Substratmaterial epitaktisch, einkristallin auf dem lackfreien Substratoberflächenbereich ab. Vorteilhafterweise ist amorphes YBaCuO bei dieser Temperatur stabil, so das sie als Lackmaske im Sinne des erfindungsgemäßen Verfahrens eingesetzt werden kann. Der sich an diesem Verfahrensschritt anschließende Lift-off-Prozeß könnte in diesem Falle mit Hilfe von verdünnter Salzsäure (HCl) durchgeführt werden.

Die der Erfindung zugrundeliegende Aufgabe wird gemäß Anspruch 8 alternativ dadurch gelöst, daß nach dem Auftragen der Lackschicht auf die für die supraleitenden Bahnen vorgesehenen Substratoberflächenbereiche die lackfreien Sustratbereiche durch Ätzen soweit abgetragen werden, daß die die Lackschicht tragenden Substratoberflächenbereiche relativ gegenüber den lackfreien Substratoberflächenbereichen erhöht sind. Da während des Ätzvorganges die für das Wachstum der HTSL-Strukturen benötigten Substratoberflächenbereiche durch die Lackmaske geschüzt sind, bleiben diese Oberflächenbereiche während des Tiefätzens unversehrt. Dies hat zur Folge, daß für die nach dem Aufdampfen der Inhibit-Dotierschicht und dem anschließenden Lift-off der Lackmaske deponierte HTSL-Schicht im Bereich der sich durch epitaktisches Wachtum herausbildenden HTSL-Strukturen Substratoberflächenbereiche höchster Qualität zur Verfügung stehen. Da die Substratoberflächenbereiche mit den darauf ausgebildeten HTSL-Bahnen durch das Tiefätzen soweit erhöht werden, daß die strukturierten Leiterbahnen von den dotierten, die Isolatorschicht tragenden Substratoberflächenbereichen isoliert, d.h. von diesen räumlich getrennt verlaufen, werden die hochwertigen HTSL-Bereiche auch nicht mehr durch laterale Diffusion des Dotierstoffes beeinträchtigt. Auch wird bei dieser Verfahrensweise nach dem Wachstum des HTSL der HTSL selbst nicht mehr geätzt und ist auch keiner Beeinflussung durch die Lackschicht ausgesetzt. Dies hat zur Folge, daß die Qualität der Supraleiterbahnen voll erhalten bleibt.

Als HTSL wird zweckmäßigerweise YBa₂Cu₃O₇₋ₓ verwendet (Anspruch 9). Desweiteren hat sich gezeigt, daß eine besonders gleichmäßige und saubere Abtragung der lackfreien Substratbereiche durch Ionenstrahlätzen erzielt wird (Anspruch 10). Selbstverständlich können aber auch andere Ätzmethoden, wie beispielsweise chemisches Ätzen, verwendet werden.

Das Endprodukt des erfindungsgemäßen Verfahrens nach einem der Ansprüche 1 bis 7 sind, wie im Anspruch 11 definiert, strukturierte Leiterbahnen aus auf einem Substrat aufgebrachter HTSL-Schicht und davon in Richtung senkrecht zur Substratoberfläche räumlich getrennte, dieser HTSL-Schicht gegenüber relativ höher liegender Isolatorschicht aus dotiertem HTSL. Dabei besteht das Substrat des erfindungsgemäßen Produktes vorzugsweise aus Strontiumtitanat (SrTiO₃) oder Lanthanaluminat (LaAlO₃), da sich auf diesem Substrat aufgrund eines besonders guten einkristallinen Wachstums hochwertige HTSL-Strukturen ausbilden; daneben ist als Substrat aber auch Yttriumstabilisiertes Zirkonoxid (YSZ) geeignet. Die Wahl des Substratmaterials ist aber keineswegs auf die hier genannten Materialien begrenzt. Vielmehr sind alle zum epitaktischen Wachstum HTSL-Schichten geeigneten Substratmaterialien einsetzbar.

Das Endprodukt des erfindungsgemäßen Verfahrens nach einem der Ansprüche 8 bis 10 sind, wie im Anspruch 15 definiert, strukturierte Leiterbahnen aus auf einem Substrat erhöht aufgebrachter HTSL-Schicht und tieferliegender Isolatorschicht aus dotiertem HTSL. Derartige Leiterbahnen sind zwar bekannt (vgl. D.K. Fork et al: Reaction patterning of YBa₂Cu₃O₇₋ₓ thin films on Si. Appl. Phys. Lett. 57(23), 1990, 2504), unterscheiden sich aber vom Endprodukt des erfindungsgemäßen Verfahrens dadurch, daß bei den erfindungsgemäßen strukturierten Leiterbahnen das Substrat aus einem für ein einkristallines Wachstum der supraleitenden Bahnen geeigneten Material besteht und die Erhöhungen von den die supraleitenden Bahnen tragenden Bereichen des Substrats gebildet werden. Demgegenüber besteht das Substrat bei den bekannten, erhöht aufgebrachten strukturierten Leiterbahnen aus einem als Dotierstoff geeigneten Substrat, so daß die Erhöhungen von einer, für das einkristalline Wachstum des HTSL geeigneten Unterlage gebildet wird.

Das Substrat des erfindungsgemäßen Produkts besteht vorzugsweise aus Strontiumtitanat (SrTiO₃), da sich auf diesem Substrat aufgrund eines besonders guten einkristallinen Wachstums hochwertige HTSL-Strukturen ausbilden; daneben ist als Substrat aber auch Lantanaluminat (LaAlO₃) oder Yttrium-stabilisiertes Zirkonoxid (YSZ) geeignet.

Ausführungsbeispiele der erfindungsgemäßen Verfahren und deren Endprodukte sind in den Zeichnungen dargestellt und werden im folgenden näher erläutert.

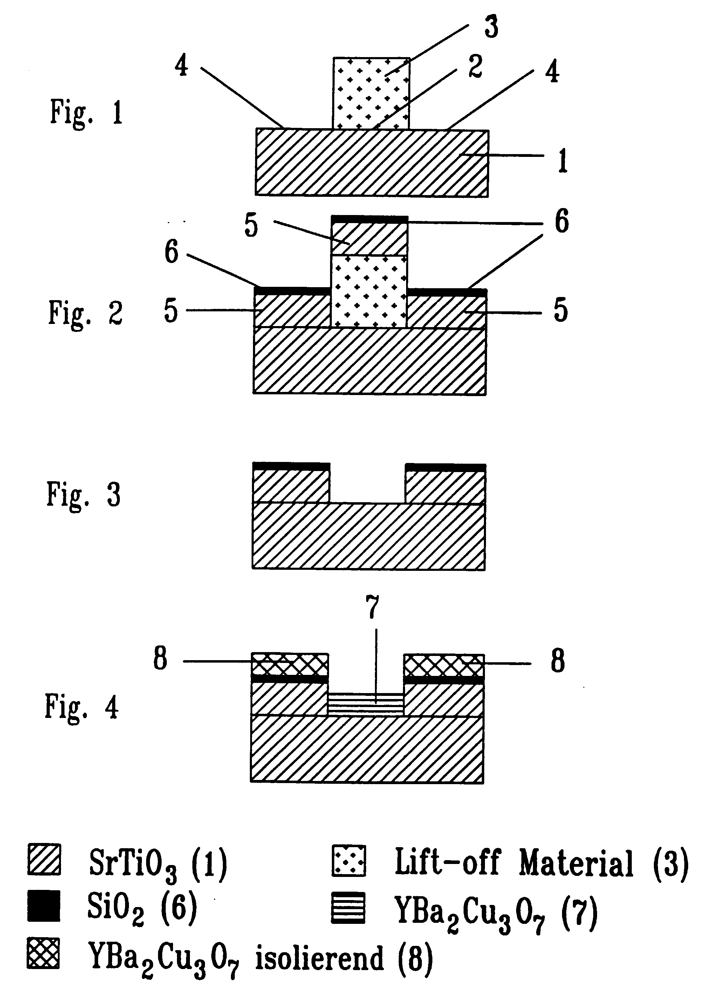

In den Figuren 1 bis 4 sind die einzelnen Stufen des Herstellungsprozesses zum alternativen Verfahren gemäß Anspruch 1 bis 7 für die strukturierten Leiterbahnen schematisch dargestellt:

Gemäß Figur 1 wird auf Strontiumtitanat (SrTiO₃) als für das einkristalline Wachstum des HTSL geeignetes Substrat 1 in den für die supraleitenden Bahnen vorgesehenen Substratoberflächenbereichen 2 die Lackschicht 3 (Photolack AZ 1512) durch photolithographische Strukturierung einer auf der Gesamtoberfläche aufgebrachten Lackschicht hergestellt. Hierauf und auf den tieferliegenden lackfreien Substratbereichen 4 werden Substratmaterial 5 - in genügender Menge -sowie anschließend als Inhibitstoff 6 vorgesehenes SiO₂ nacheinander abgeschieden, wie in Figur 2 dargestellt.

In einem nachfolgenden Lift-off-Prozeß wird der Photolack mittels Aceton abgehoben. Die damit verbundene Entfernung der sich auf dem Photolack befindlichen Struktur aus abgeschiedenem Substratmaterial 5 und Inhibitstoff SIO2 führt zur Freilegung der zur Bildung der HTSL-Bahnen vorgesehenen Oberflächenbereichen (Figur 3).

In einem nächsten Verfahrensschritt erfolgt das epitaktische Wachstum der HTSL-Schicht 7 und 8. Die Diffusion des Inhibitstoffs 6 in den abgeschiedenen HTSL-Schichtbereichen 8 führt dort zu einer Vergiftung des HTSL-Materials zu einem Material mit isolierender Eigenschaft. Das epitaktische Wachstum in den Substratoberflächenbereichen 2 ergibt aufgrund der bis dahin erfolgte vertikale Strukturierung der Substratoberfläche ohne weiteres die erwünschte Leiterbahnenstruktur.

Für den Fall, daß die strukturierte Lackschicht 3 aus amorphem YBaCuO - im Bereich von Raumtemperatur -hergestellt wurde, kann SrTiO₃ als Substratmaterial epitaktisch, einkristallin bei hohen Temperaturen im Bereich von 800°C abgeschieden werden.

Im übrigen kann es zweckmäßig, oder vorteilhaft sein, als abzuscheidendes Substratmaterial 5 das Material des Substrates 1 zu wählen. Möglich ist allerdings auch die Wahl unterschiedlicher Materialien als Substrat 1 und abzuscheidendes Substratmaterial 5.

Eine weiter Möglichkeit liegt darin, auf der hergestellten HTSL-Leiterbahn 7 weiteres Material, vorzugsweise einer der vorher erwähnten Substratmaterialien, auf der Leiterbahn 7 abzuscheiden. Damit wird eine vollständige, die Leiterbahn abkapselnde Passivierung erreicht. Im Ergebnis liegt dann eine im Substratmaterial vergrabene HTSL-Leiterbahn vor. Nachteilige Einflüsse von außen auf die Qualität der Leiterbahn können damit weiter herabgesetzt werden.

In der Figur 5a-d sind die einzelnen Stufen des Herstellungsprozeß zum alternativen Verfahren gemäß Anspruch 8 bis 10 für die sturkturierten Leiterbahnen schematisch dargestellt:

Gemäß Figur 5a wird auf Strontiumtitanat (SrTiO₃) als für das einkristalline Wachstum des HTSL geeignetes Substrat 11 in den für die supraleitenden Bahnen vorgesehenen Substratoberflächenbereiche 12 die Lackschicht 13 aufgetragen. Die tieferliegenden lackfreien Substratbereiche 14 werden durch Ionenätzen ↓ abgetragen, so daß die die Lackschicht 13 tragende Substratoberfläche 12 gegenüber den lackfreien Substratoberflächen 14 relativ erhöht ist. Als Substrat 11 können neben SrTiO₃ auch andere, für das epitaktische Wachstum des HTSL geeignete Substanzen, wie beispielsweise Zirkonoxid (ZrO₂) oder Lantanaluminat (LaAlO₃) verwendet werden.

Als nächstes wird laut Figur 5b auf die gesamte Oberfläche als Dotierstoff 15 Silizium aufgedampft. Anschließend wird die Lackschicht 13 mit dem darauf befindlichen Dotierstoff 15 wieder von der Substratoberfläche 12 abgehoben, so daß laut Figur 5c die erhöht liegende Substratoberfläche 12 für das epitaktische Wachstum des HTSL frei wird, während auf den Oberflächenbereichen der tieferliegenden Substratbereiche 14 das Silizium 15 verbleibt.

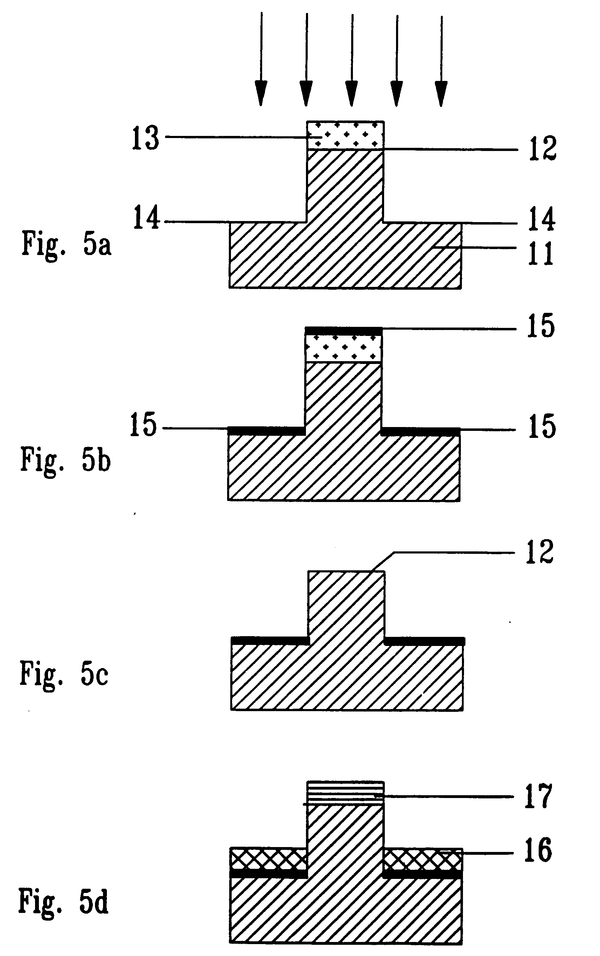

In Figur 5d ist schließlich das Endprodukt des erfindungsgemäßen Verfahrens nach Auftragen von YBa₂Cu₃O₇₋ₓ als HTSL gezeigt: Während sich auf den tieferliegenden Substratoberflächen 14 durch Diffusion des Siliziums 15 das YBa₂Cu₃O₇₋ₓ zum Isolator 16 entwickelt hat, ist auf der erhöhten Substratoberfläche 12 durch epitaktisches Wachstum des YBa₂Cu₃O₇₋ₓ die Leiterbahn 17 entstanden.

## Patentansprüche

1. Verfahren zur Herstellung von strukturierten Leiterbahnen aus Hochtemperatursupraleiter (HTSL)-Schichten, bei dem auf die Oberfläche eines für ein einkristallines Wachstum der supraleitenden Bahnen geeigneten Substrates in den für die HTSL-Bahnen vorgesehenen Bereichen eine Lackschicht als Lackmaske aufgebracht wird und anschließend auf die gesamte Substratoberfläche eine Schicht eines Inhibit-Dotierstoffes aufgedampft wird, die durch einen Lift-off der Lackmaske von den für die supraleitenden Bahnen vorgesehenen Oberflächenbereichen wieder abgehoben wird, so daß nach anschließendem Deponieren der HTSL-Schicht auf das Substrat bei gleichzeitiger oder nachfolgender Temperung der HTSL-Schicht auf der dotierten Substratoberfläche durch Diffusion des Inhibit-Dotierstoffes zu einer Isolatorschicht wird und sich auf der undotierten Substratoberfläche durch epitaktisches Wachstum zu den supraleitenden Bahnen ausbildet, wobei nach dem Auftragen der Lackschicht (3) auf die für die supraleitenden Bahnen vorgesehenen Substratoberflächenbereiche (2) soviel Substratmaterial (5) in den lackfreien Substratbereichen (4) abgeschieden wird, daß die HTSL-Leiterbahnen (7), die nach dem Aufdampfen der Inhibit-Dotierschicht (6) und dem anschließenden Lift-off der Lackmaske auf den dadurch freigelegten Substratoberflächenbereichen deponiert und durch epitaktisches Wachstum ausgebildet werden, räumlich isoliert von den dotierten, die Isolatorschicht (8) tragenden, nunmehr relativ höherliegenden Substratoberflächenbereichen (4) verlaufen.

2. Verfahren nach Anspruch 1, wobei als HTSL YBa₂Cu₃O₇₋ₓ verwendet wird.

3. Verfahren nach Anspruch 1 oder 2, wobei die Abscheidung des Substratmaterials (5) bei Raumtemperatur erfolgt.

4. Verfahren nach einem der Ansprüche 1 bis 3, wobei amorphes Substratmaterial (5) bei Raumtemperatur abgeschieden wird.

5. Verfahren nach Anspruch 1 oder 2, wobei das Substratmaterial (5) in den lackfreien Substratbereichen bei Temperaturen im Bereich von 500°C-850°C abgeschieden wird.

6. Verfahren nach einem der vorherigen Ansprüche, wobei als abzuscheidendes Substratmaterial (5) das Material des die strukturierten Leiterbahnen tragenden Substrates gewählt wird.

7. Verfahren nach einem der vorherigen Ansprüche, wobei als Material für die zwecks Durchführung des Lift-Prozesses vorgesehene, strukturierte Lackschicht (3) amorphes YBaCuO gewählt wird.

8. Verfahren zur Herstellung von strukturierten Leiterbahnen aus Hochtemperatursupraleiter (HTSL)-Schichten, bei dem auf die Oberfläche eines für ein einkristallines Wachstum der supraleitenden Bahnen geeigneten Substrates in den für die HTSL-Bahnen vorgesehenen Bereichen eine Lackschicht als Lackmaske aufgebracht wird und anschließend auf die gesamte Substratoberfläche eine Schicht eines Inhibit-Dotierstoffes aufgedampft wird, die durch einen Lift-off der Lackmaske von den für die supraleitenden Bahnen vorgesehenen Substratoberflächenbereichen wieder abgehoben wird, so daß nach anschließendem Deponieren der HTSL-Schicht auf das Substrat bei gleichzeitiger oder nachfolgender Temperung der HTSL-Schicht auf der dotierten Substratoberfläche durch Diffusion des Inhibit-Dotierstoffes zu einer Isolatorschicht wird und sich auf der undotierten Substratoberfläche durch epitaktisches Wachstum zu den supraleitenden Bahnen ausbildet, wobei nach dem Auftragen der Lackschicht (13) auf die für die supraleitenden Bahnen vorgesehenen Substratoberflächenbereiche (12) die lackfreien Substratbereiche (14) durch Ätzen soweit abgetragen werden, daß die die Lackschicht (13) tragenden Substratoberflächenbereiche (12) relativ gegenüber den lackfreien Substratoberflächenbereichen (14) soweit erhöht sind, daß die nach dem Aufdampfen der Inhibit-Dotierschicht (15) und dem anschließenden Lift-off der Lackmaske deponierten und durch epitaktisches Wachstum ausgebildeten HTSL-Leiterbahnen (17) auf der erhöhten Substratoberfläche (12) räumlich isoliert von den dotierten, die Isolatorschicht (16) tragenden Substratoberflächenbereichen (14) verlaufen.

9. Verfahren nach Anspruch 8, wobei als HTSL YBa₂CU₃O₇₋ₓ verwendet wird.

10. Verfahren nach Anspruch 8 oder 9, wobei die lackfreien Substratbereiche (14) durch Ionenstrahlätzen abgetragen werden.

11. Strukturierte Leiterbahnen aus auf einem Substrat aufgebrachter einkristalliner Hochtemperatursupraleiter (HTSL)-Schicht mit zwecks lateraler Begrenzung der Leiterbahnen vorgesehener Isolatorschicht aus dotiertem HTSL-Material, bei denen das Substrat (1) aus einem für ein einkristallines Wachstum der supraleitenden Leiterbahnen geeigneten Material besteht, und die die HTSL-Leiterbahnen (7) tragenden Substratoberflächenbereiche gegenüber den die zwecks Begrenzung der Leiterbahnen vorgesehenen Isolatorschicht tragenden Substratoberflächenbereichen (4) soweit in Richtung senkrecht zur Substratoberfläche gegeneinander versetzt sind, daß die HTSL-Leiterbahnen (7) seitlich von Substratmaterial (5) begrenzt und von der auf den relativ erhöhten Substratoberflächenbereichen aufgebrachten Isolatorschicht (8) räumlich getrennt sind.

12. Strukturierte Leiterbahnen nach Anspruch 11, bei denen auf den strukturierten HTSL-Leiterbahnen (7) zwecks Passivierung weiteres Substratmaterial aufgebracht ist.

13. Strukturierte Leiterbahnen nach Anspruch 11 oder 12, bei denen das Substrat (1) aus Strontiumtitanat (SrTiO₃), Lantanaluminat (LaAlO₃) oder Yttrium-stabilisiertem Zirkonoxid (YSZ) besteht.

14. Strukturierte Leiterbahnen nach einem der Ansprüche 11 bis 13, bei denen die HTSL-Leiterbahnen (7) seitlich begrenzendes, epitaktisch gewachsenes Substratmaterial (5) verwendet ist.

15. Strukturierte Leiterbahnen aus auf einem Substrat erhöht aufgebrachter einkristalliner Hochtemperatursupraleiter (HTSL)-Schicht und tieferliegender Isolatorschicht aus dotiertem HTSL-Material, bei denen das Substrat (11) aus einem für ein einkristallines Wachstum der supraleitenden HTSL-Leiterbahnen (17) geeigneten Material besteht, und die Erhöhungen von den die supraleitenden HTSL-Leiterbahnen (17) tragenden Bereichen des Substrates (12) gebildet werden, so daß die HTSL-Leiterbahnen von der tieferliegenden Isolatorschicht (16) räumlich getrennt sind.

16. Strukturierte Leiterbahnen nach Anspruch 15, bei denen das Substrat (11) aus Strontiumtitanat (SrTiO₃), Lantanaluminat (LaAlO₃) oder Yttrium-stabilisiertem Zirkonoxid (YSZ) besteht.

## Claims

1. Process for making structured conductor tracks from high-temperature supraconductor (HTSC) layers, involving applying a resist layer as a resist mask onto the surface of a substrate suitable for monocrystalline growth of the supraconducting tracks in the zones envisaged for the HTSC tracks and then evaporating on to the entire surface of the substrate a layer of an inhibit dopant which is taken off again by lifting off the resist mask from those surface zones that are destined to become the supraconducting tracks, with the result that after then depositing the HTSC layer onto the substrate and simultaneously or subsequently tempering the HTSC layer on the doped substrate surface, diffusion of the inhibit dopant makes the HTSC layer into an insulating layer which on the undoped substrate surface develops into the supraconducting tracks as a result of epitactical growth; following the application of the resist layer (3) onto the substrate surface zones (2) envisaged for the supraconducting tracks, sufficient substrate material (5) is deposited in the resist-free substrate zones (4) for the HTSC conductor tracks (7), which following evaporation of the inhibiting dopant layer (6) and the subsequent lifting-off of the resist mask are deposited on the substrate surface zones exposed by said lifting-off process and are formed by epitactical growth, to extend in a spatially insulated manner from the doped zones (4) of the substrate surface which bear the insulating layer (8) and are now situated relatively higher.

2. Process according to claim 1, in which YBa₂Cu₃O₇₋ₓ is used as the HTSC.

3. Process according to claim 1 or 2, in which the substrate material (5) is deposited at room temperature.

4. Process according to any of claims 1 to 3, in which amorphous substrate material (5) is deposited at room temperature.

5. Process according to claim 1 or 2, in which the substrate material (5) is deposited in the resist-free substrate zones at temperatures within the range 500°C to 850°C.

6. Process according to any of the preceding claims, in which the material of the substrate bearing the structured conductor tracks is chosen as the substrate material (5) to be deposited.

7. Process according to any of the preceding claims, in which amorphous YBaCUO is chosen as the material for the structured resist layer (3) provided for the purpose of effecting the lift-off process.

8. Process for making structured conductor tracks from high-temperature supraconductor (HTSC) layers, involving applying a resist layer as a resist mask onto the surface of a substrate suitable for monocrystalline growth of the supraconducting tracks in the zones envisaged for the HTSC tracks and then evaporating on to the entire surface of the substrate a layer of an inhibit dopant which is taken off again by lifting off the resist mask from those surface zones that are destined to become the supraconducting tracks, with the result that after then depositing the HTSC layer onto the substrate and simultaneously or subsequently tempering the HTSC layer on the doped substrate surface, diffusion of the inhibit dopant makes the HTSC layer into an insulating layer which on the undoped substrate surface develops into the supraconducting tracks as a result of epitactical growth; following the application of the resist layer (13) onto the substrate surface zones (12) envisaged for the supraconducting tracks, the resist-free substrate zones (14) are sufficiently eroded by etching for the substrate surface zones (12) bearing the resist layer (13) to be relatively raised with respect to the resist-free substrate surface zones (14) sufficiently for the HTSC conductor tracks (17) deposited and developed due to epitactical growth once the inhibit dopant layer (15) has been evaporated and the resist mask subsequently lifted off to extend in a spatially insulated manner from the doped substrate surface zones (14) bearing the insulating layer (16).

9. Process according to claim 8, in which YBa₂Cu₃O₇₋ₓ is used as HTSC.

10. Process according to claim 8 or 9, in which the resist-free substrate zones (14) are eroded by ion beam etching.

11. Structured conductor tracks made from a monocrystalline high-temperature supraconductor (HTSC) layer applied on a substrate, having an insulating layer of doped HTSC material provided for the purpose of laterally delimiting the conductor tracks, where the substrate (1) consists of a material suitable for monocrystalline growth of the supraconducting conductor tracks, and the substrate surface zones bearing the HTSC conductor tracks (7) are sufficiently offset from one another, in a direction perpendicular to the substrate surface, with respect to the substrate surface zones (4) bearing the insulating layer provided for the purpose of delimiting the conductor tracks, for the HTSC conductor tracks (7) to be delimited laterally by substrate material (5) and to be spatially separated from the insulating layer (8) applied on the relatively raised substrate surface zones.

12. Structured conductor tracks according to claim 11, where additional substrate material has been applied on the structured HTSC conductor tracks (7) for the purpose of passivation.

13. Structured conductor tracks according to claim 11 or 12, where the substrate (1) consists of strontium titanate (SrTiO₃), lanthanum aluminate (LaAlO₃) or yttrium-stabilised zirconium oxide (YSZ).

14. Structured conductor tracks according to any of claims 11 to 13, where epitactically grown substrate material (5) which laterally delimits the HTSC conductor tracks (7) is used.

15. Structured conductor tracks made from a monocrystalline high-temperature supraconductor (HTSC) layer applied as a raised portion on a substrate and a lower-lying insulating layer of doped HTSC material, where the substrate (11) consists of a material suitable for monocrystalline growth of the supraconducting HTSC conductor tracks (17), and the raised portions are formed by the zones of the substrate (12) that bear the supraconducting HTSC conductor tracks (17), with the result that HTSC conductor tracks are spatially separated from the lower-lying insulating layer (16).

16. Structured conductor tracks according to claim 15, where the substrate (11) consists of strontium titanate (SrTiO₃), lanthanum aluminate (LaAlO₃) or yttrium-stabilised zirconium oxide (YSZ).

## Revendications

1. Procédé pour fabriquer des voies conductrices structurées formées de couches supraconductrices à haute température (HTSL), selon lequel on dépose une couche de laque en tant que masque de laque sur la surface d'un substrat convenant pour réaliser une croissance monocristalline des pistes supraconductrices, dans des zones prévues pour les pistes HSTL et ensuite on dépose par évaporation, sur l'ensemble de la surface du substrat, une couche formée d'un dopant d'inhibition et qu'on élimine à nouveau au moyen d'un décollement lift-off du masque de laque à partir des zones de la surface prévues pour les voies supraconductrices, de sorte qu'après le dépôt ultérieur de la couche HTSL sur le substrat, lors d'un recuit simultané ou ultérieur, la couche HTSL se transforme, sur la surface dopée du substrat, en une couche isolante par diffusion du dopant d'inhibition et, sur la surface non dopée du substrat, se transforme, sous l'effet d'une croissance épitaxiale, en les voies supraconductrices, auquel cas à la suite du dépôt de la couche de laque (3), on dépose sur les zones (2) de la surface du substrat, qui sont prévues pour les voies supraconductrices, une quantité telle du matériau du substrat (5) dans les zones du substrat (4) qui ne portent pas de laque, que les voies conductrices HTSL (7), qui après le dépôt par évaporation de la couche de dopant d'inhibition (6) et après le décollement lift-off ultérieur du masque de laque sont déposées sur les zones ainsi libérées de la surface du substrat et sont formées par croissance épitaxiale, s'étendent en étant isolées, spatialement, par rapport aux zones dopées (4) de la surface du substrat, qui portent la couche isolante (8) et sont maintenant situées à un niveau relativement plus élevé.

2. Procédé selon la revendication 1, dans lequel on utilise comme HTSL du YBa₂Cu₃O₇₋ₓ.

3. Procédé selon la revendication 1 ou 2, selon lequel le dépôt du matériau (5) du substrat s'effectue à la température ambiante.

4. Procédé selon l'une des revendications 1 à 3, selon lequel on dépose le matériau amorphe du substrat (5) à la température ambiante.

5. Procédé selon la revendication 1 ou 2, selon lequel on dépose le matériau du substrat (5) dans les zones du substrat non pourvues de laque, à des températures comprises dans la gamme 500°C-850°C.

6. Procédé selon l'une des revendications précédentes, selon lequel on choisit, comme matériau de substrat (5) devant être déposé, le matériau du substrat qui porte les voies conductrices structurées.

7. Procédé selon l'une des revendications précédentes, selon lequel on choisit du YBaCuO amorphe en tant que matériau pour la couche de laque structurée (3) prévue pour la mise en oeuvre du procédé de décollement lift.

8. Procédé pour fabriquer des voies conductrices structurées formées de couches supraconductrices à haute température (HTSL), selon lequel on dépose une couche de laque en tant que masque de laque sur la surface d'un substrat convenant pour réaliser une croissance monocristalline des pistes supraconductrices, dans des zones prévues pour les pistes HSTL et ensuite on dépose par évaporation, sur l'ensemble de la surface du substrat, une couche formée d'un dopant d'inhibition, qu'on élimine à nouveau au moyen d'un décollement lift-off du masque de laque à partir des zones de la surface prévues pour les voies supraconductrices, de sorte qu'après le dépôt ultérieur de la couche HSTL sur le substrat, lors d'un recuit simultané ou ultérieur, la couche HSTL se transforme, sur la surface dopée du substrat,en une couche isolante par diffusion du dopant d'inhibition et, sur la surface non dopée du substrat, se transforme, sous l'effet d'une croissance épitaxiale, les voies supraconductrices, auquel cas à la suite du dépôt de la couche de laque (13), sur les zones (12) de la surface du substrat, qui sont prévues pour les voies supraconductrices, on élimine par corrosion les zones (14) du substrat non pourvues de laque, au point que les zones (12) de la surface du substrat, qui portent la couche de laque (13), sont surélevées par rapport aux zones (14) de la surface du substrat non pourvues de laque au point que les voies conductrices HTSL (17), qui sont déposées après le dépôt par évaporation de la couche de dopant d'inhibition (15) et le décollement lift-off ultérieur du masque de laque et sont formées par croissance épitaxiale, s'étendent sur la surface surélevée (12) du substrat, en étant isolées spatialement par rapport aux zones dopées (14) de la surface du substrat, qui portent la couche isolante (16).

9. Procédé selon la revendication 8, selon lequel on utilise comme HTSL du YBa₂Cu₃O₇₋ₓ.

10. Procédé selon la revendication 8 ou 9, selon lequel on élimine les zones (14) du substrat, non pourvues de laque, au moyen d'une corrosion à l'aide d'un faisceau d'ions.

11. Voies conductrices structurées constituées par une couche monocristalline d'un supraconducteur à haute température (HTSL) déposée sur un substrat, comportant une couche isolante prévue pour limiter latéralement les voies conductrices et constituée par un matériau HTSL dopé, et dans lesquelles le substrat (1) est réalisé en un matériau convenant pour une croissance monocristalline des voies supraconductrices, et les parties de la surface du substrat, qui portent les voies conductrices HTSL (7), sont décalées par rapport aux zones (4) de la surface du substrat, qui portent la -couche isolante prévue pour limiter les voies conductrices, dans une direction perpendiculaire à la surface du substrat de telle sorte que les voies conductrices HTSL (7) sont limitées latéralement par le matériau (5) du substrat et sont séparées spatialement de la couche isolante (8) déposée sur les zones relativement surélevées de la surface du substrat.

12. Voies conductrices structurées selon la revendication 11, dans lesquelles on dépose un autre matériau de substrat sur les voies conductrices HTSL structurées (7) pour réaliser une passivation.

13. Voies conductrices structurées selon la revendication 11 ou 12, dans lesquelles le substrat (1) est constitué par du titanate de strontium (SrTiO₃), de l'aluminate de lanthane (LaAlO₃) ou de l'oxyde de zirconium (YSZ) stabilisé par de l'yttrium.

14. Voies conductrices structurées selon l'une des revendications 11 à 13, dans lesquelles on utilise un matériau de substrat (5) formé par croissance épitaxiale et limitant latéralement les voies conductrices (7) en HTSL.

15. Voies conductrices structurées constituées par une couche monocristalline supraconductrice à haute température (HTSL) déposée en surélévation sur un substrat, et par une couche isolante plus profonde formée d'un matériau HTSL dopé, et dans lesquelles le substrat (11) est formé d'un matériau convenant pour la croissance monocristalline des voies conductrices HTSL supraconductrices (17) et les surélévations sont formées par les zones du substrat (12), qui portent les voies conductrices HTSL (17) de sorte que les voies conductrices HTSL sont séparées spatialement de la couche isolante plus profonde (16).

16. Voies conductrices structurées selon la revendication 15, dans lesquelles le substrat (11) est constitué par du titanate de strontium (SrTiO₃), de l'aluminate de lanthane (LaAlO₃) ou de l'oxyde de zirconium (YSZ) stabilisé par de l'yttrium.
